# EUROPÄISCHE PATENTSCHRIFT

(11) **EP 1 221 072 B1**
(45) Veröffentlichungstag und Bekanntmachung des Hinweises auf die Patenterteilung: **08.06.2005**
(21) Anmeldenummer: 99955723.4
(22) Anmeldetag: 17.09.1999
(51) Int. Cl.: G03F 1/00, G03F 7/20

(54) **KONTAKTLOCHHERSTELLUNG MIT HILFE SICH KREUZENDER PHASENSPRUNGKANTEN EINER EINZIGEN PHASENMASKE**
CONTACT HOLE PRODUCTION BY MEANS OF CROSSING SUDDEN PHASE SHIFT EDGES OF A SINGLE PHASE MASK
REALISATION DE TROUS DE CONTACT A L'AIDE DE BORDS DE SAUT DE PHASE D'UN SEUL MASQUE DE PHASE

(43) Veröffentlichungstag der Anmeldung: 10.07.2002
(73) Patentinhaber: Infineon Technologies AG, 81669 München (DE)
(72) Erfinder: GRASSMANN, Andreas, Hopewell Junction, NY 12533 (US); FRIEDRICH, Christoph, D-81245 München (DE); GRIESINGER, Uwe, D-85646 Anzing (DE); PFORR, Rainer, D-01108 Dresden (DE); WIDMANN, Dietrich, (DE)
(74) Vertreter: Kindermann, Peter
(86) Internationale Anmeldenummer: PCT/DE1999/002968
(87) Internationale Veröffentlichungsnummer: WO 2001/022164

(56) Entgegenhaltungen:
- EP-A- 0 464 492
- DE-A- 19 545 163
- US-A- 5 533 634

## Beschreibung

Die Erfindung betrifft die Verwendung einer Phasenmaske zum lithographischen Erzeugen kleiner Strukturen an der Grenze einer durch die Wellenlänge einer Strahlung vorgegebenen Auflösung, mit ersten Bereichen und gegenüber den ersten Bereichen phasenschiebenden zweiten Bereichen neben den ersten Bereichen zur Erzeugung eines Phasensprungs entlang von Grenzen zwischen den ersten und den zweiten Bereichen.

Die Erfindung betrifft ferner ein Verfahren zum lithographischen Erzeugen dieser Strukturen, bei dem ein Gegenstand in der Weise durch eine oder mehrere Phasenmasken belichtet wird, das Linien geringer Strahlungsintensität so auf den Gegensand projiziert werden, daß sie sich auf diesem schneiden.

Derartige Phasenmasken und Verfahren sind in US 5,766,829 offenbart. Die dort beschriebene Phasenmaske weist eine Vielzahl paralleler streifenförmiger Erhebungen auf. In der Halbleitertechnik wird durch solche sogenannten Phasenmasken Licht auf zu strukturierende Schichten von Halbleitersubstraten projiziert, um kleinste Strukturen der Größe teilweise unterhalb der Wellenlänge der Strahlung zu erzeugen. Die Erhebungen sind so groß gewählt, daß zwei Lichtstrahlen, von denen der eine die Phasenmaske im Bereich der Erhebung passiert, zueinander einen Phasenunterschied von 180° aufweisen. Dies führt bei Abmessungen der Erhebungen im Bereich der Wellenlänge zu einer Auslöschung transmittierter Strahlung unterhalb der Kanten der Erhebungen. Bei Belichtung durch eine Maske mit parallelen streifenförmigen Erhebungen entstehen auf der belichteten Fläche des Halbleitersubstrats parallele, unbelichtete Streifen in einer ansonsten belichteten Fläche. Wird ein solches Streifenmuster ein zweites Mal, jedoch um einen gewissen Winkel verdreht, auf dieselbe Fläche belichtet, so entsteht auf der Fläche eine Struktur aus isolierten, unbelichteten Punkten, wohingegen die dazwischen liegenden Bereiche der projizierten Phasensprungkanten mit halber Intensität und die übrigen Flächenbereiche mit voller Lichtintensität belichtet sind. Durch Entwicklung eines so belichteten Lackfilms entsteht ein Muster isolierter Punkte, das sich zur Herstellung von Kontaktlöchern kleinster Abmessungen eignet.

In US 5,766,829 wird die Kontaktlochstruktur dadurch erzeugt, daß zwei Phasenmasken oder zwei verschiedene Bereiche einer Phasenmaske nacheinander auf das Halbleitersubstrat belichtet werden. Somit sind für die Erzeugung jeder Kontaktlochstruktur stets zwei Belichtungsschritte erforderlich. In der Massenfertigung integrierter Halbleiterschaltungen hingegen ist eine möglichst effiziente und kostensparende Produktionsweise ein wesentliches Ziel. Dieses Ziel wird um so eher erreicht, je weniger Herstellungsanlagen und je weniger Prozeßschritte zur Herstellung integrierter Schaltungen erforderlich sind. Derzeitige Belichtungsgeräte zur Belichtung von Halbleitersubstraten kosten ein- bis zweistellige Millionenbeträge, die durch einen entsprechenden Durchsatz während des Betriebs erwirtschaftet werden müssen. Moderne Belichtungsgeräte belichten ca. 60 Halbleitersubstrate pro Stunde; eine Zahl, die sich bei einer Doppelbelichtung halbiert und dementsprechend Kostennachteile mit sich bringt.

Aus der deutschen Offenlegungsschrift DE 195 45 163 A 1 ist eine Phasenschiebermaske zur Bildung von Kontaktlöchern mit Mikroabmessungen bekannt. Die Phasenschiebermaske enthält abwechselnd Phasenschieberschichtmuster und freiliegende Abschnitte eines Quarzsubstrates. Das durch die Phasenschiebermaske hindurch tretende Licht hat eine starke Intensität in den zentralen Abschnitten jedes Phasenschieberschichtmusters und jedes freiliegenden Abschnittes des Quarzsubstrates. Die Lichtintensität nimmt zu der Grenze zwischen jedem Phasenschieberschichtmuster und jedem freiliegenden Abschnitt des Quarzsubstrates, die benachbart zueinander angeordnet sind, allmählich ab. Diese Grenze verhindert, dass Licht dort hindurchtritt. Demnach können Kontaktlöcher mit Mikroabmessungen in dem Wafer an Bereichen nicht gebildet werden, wo das Licht nicht hindurchtreten kann.

Aus der europäischen Offenlegungsschrift EP 0 464 492 A1 ist eine für die Fotolithografie verwendete Fotomaske und ein Herstellungsverfahren für diese Maske bekannt. Gemäß einem Ausführungsbeispiel, das eine zum Herstellen von Kontaktlöchern verwendete Phasenmaske zeigt, enthält die Phasenmaske schachbrettartig angeordnete Bereich, wobei es quadratische Phasenschieberbereiche, rechteckige Phasenschieberbereiche, quadratische Substratbereiche und rechteckige Substratbereiche gibt. An den Grenzen der Bereiche tritt eine Phasenverschiebung auf, die zu einer Reduzierung der Lichtintensität führt.

Aus der US-Patentschrift 5,533,634 ist eine chromlose Phasenschiebermaske bekannt, die schachbrettartig angeordnete phasenschiebende Bereiche und Bereiche eines Substrates hat. Ein abzubildendes Muster auf der Maske wird durch einen auf der Maske verbleibenden Teil des Schachbrettmusters gebildet.

Es ist daher die Aufgabe der vorliegenden Erfindung, eine Verwendung für eine Phasenmaske und ein Verfahren bereitzustellen, mit dem Kontaktlöcher und andere kleinste Strukturen ohne die erwähnten Kostennachteile, d. h. mit Hilfe eines einzigen Belichtungsschrittes hergestellt werden können.

Diese Aufgabe wird gemäß Patentanspruch 1 insbesondere dadurch gelöst, daß erste Bereiche der Phasenmaske sich über Ecken an Punkten berühren, an denen sich auch zweite Bereiche über Ecken berühren, so daß an diesen Punkten Grenzen zwischen ersten und zweiten Bereichen zusammenlaufen und diese Punkte für die Strahlung undurchlässig sind. Hinsichtlich des Verfahrens wird die Aufgabe dadurch gelöst, daß das Halbleitersubstrat oder ein anderer Gegenstand durch eine derart gekennzeichnete Phasenmaske und somit nur ein einziges Mal belichtet wird.

Die erfindungsgemäße Phasenmaske besitzt zur Kontaktlochherstellung Punkte, die in azimutaler Richtung von erhöhten und nicht erhöhten Maskenfeldern in abwechselnder Reihenfolge umgeben sind. An den Kanten zwischen den erhöhten und den nicht erhöhten Bereichen entstehen aufgrund der Phasensprünge intensitätsmindernde Interferenzen, die in dem Punkt, an dem sich die Felder über Ecken berühren, sich gegenseitig auslöschen. Durch diese Maskengestaltung ist es möglich, ein Muster, das nur in zwei Schritten erzeugen läßt, auf einem einzigen Bereich einer Phasenmaske zu verwirklichen. Dabei ist es unerheblich, ob die gegenüber den ersten Bereichen phasenschiebende Bereiche erhöht, vertieft oder gemischt erhöht und vertieft sind; wesentlich ist lediglich die Anordnung der einzelnen Maskenfelder dergestalt, daß sie sich in der genannten Weise über Ecken berühren.

Bevorzugte Ausführungsformen sehen vor, daß die Punkte Schnittpunkte von Grenzen - insbesondere Kreuzungspunkte von Grenzlinien - zwischen ersten und zweiten Bereichen sind. Im einfachsten Fall ist ein Schnittpunkt von vier Maskenfeldern umgeben, deren Kantenlinien sich vorzugsweise im rechten Winkel kreuzen. In diesem Fall können in der Umgebung des das Kontaktloch abbildenden Punktes die Maskenfelder im ersten und dritten Quadranten erhöht sein gegenüber denjenigen im zweiten und vierten Quadranten. Die Veränderung der Maskendicke durch das Vorsehen erhöhter oder vertiefter Bereiche ist zugleich die einfachste Möglichkeit, Phasensprünge der die Maske transmittierenden Strahlung zu erzeugen.

Eine bevorzugte Ausführungsform sieht vor, daß die Phasensprungkanten zwischen den ersten und den zweiten Bereichen einen Phasensprung von einer halben Wellenlänge erzeugen. In diesem Fall führt die Projektion dieser Kanten zu einer 50 %-igen Belichtung.

Vorzugsweise ist vorgesehen, daß die ersten und die zweiten Bereiche aus der Phasenmaske schachbrettartig, d. h. in abwechselnder Reihenfolge angeordnet sind, wobei die Form einzelner Maskenfelder auch rechteckig oder rautenförmig sein kann. Mit einer derartigen Maske läßt sich eine Vielzahl von Kontaktlöchern auf einfache Weise herstellen.

Hinsichtlich des Verfahrens wird die der Erfindung zugrundeliegende Aufgabe dadurch gelöst, das mit Hilfe einer erfindungsgemäßen Phasenmaske und somit nur ein einziges Mal belichtet wird. Mit Blick auf die Halbleitertechnologie sehen bevorzugte Ausführungsarten vor, daß auf diese Weise ein Flächenbereich eines Halbleitersubstrats belichtet wird, und daß Kontaktlöcher erzeugt werden.

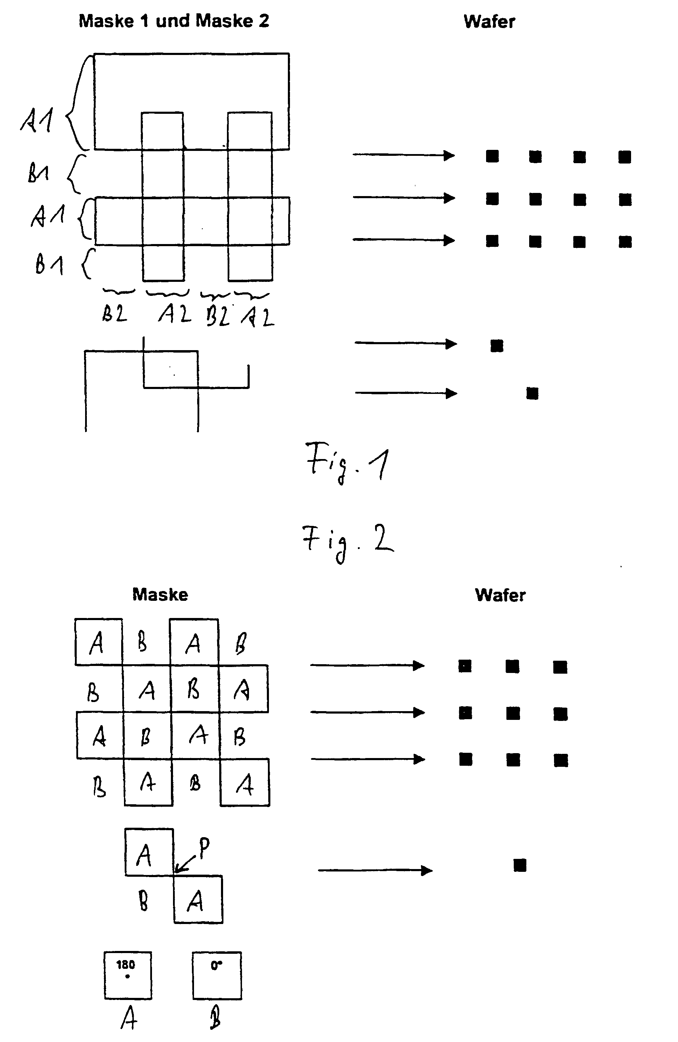

Die Erfindung wird nachstehend anhand der Figuren 1 und 2 erläutert.

Figur 1 stellt die herkömmliche Herstellung von Kontaktlochmustern mit Hilfe zweier Phasenmasken oder zweier Bereiche einer Phasenmaske dar. Eine erste Maske weist zwei horizontale und gegenüber der Maskenoberfläche B1 erhöhte Streifen A1 auf, die gegenüber den Streifen B2 eine Phasenverschiebung von einer halben Wellenlänge erzeugen. Analog weist eine zweite Maske gegenüber ihrer Maskenebene B2 erhöhte Bereiche A2 auf. Durch die aufeinanderfolgende Projektion beider Masken entstehen an den Kreuzungspunkten P der Kantenstufen zwischen A1 und B1 bzw. A2 und B2 kleinste unbelichtete Quadrate, die auf den Wafern nach dem Entwickeln der Maske zur Strukturierung von Kontaktlöchern benutzt werden können.

Figur 2 zeigt eine erfindungsgemäße Maske und das mit ihr auf das Halbleitersubstrat belichtete Kontaktlochmuster. Durch die schachbrettartige Anordnung von erhöhten und daher phasenschiebenden Maskenfeldern A gegenüber Maskenfeldern B läßt sich dieselbe Struktur wie in Figur 1 mit Hilfe einer einzigen Maske, d.h. mit halb so großen Belichtungskosten fertigen.

Entsprechend der Wahl eines Positiv- oder Negativlacks können Lacksäulen oder Lacköffnungen kleinster Abmessungen hergestellt werden. Die erzeugten punktförmigen Strukturen können beispielsweise zwei Drittel der Belichtungswellenlänge breit sein.

Weitere Ausführungen der Erfindung neben den bereits beschriebenen ergeben sich bei Anwendung der Kenntnisse und Fähigkeiten des Fachmanns. Beispielsweise können als Phasenmasken Glasmasken verwendet werden, deren phasenschiebende Bereiche durch eine selektive Ätzung erzeugt werden. Die zwischen den Kontaktlochpunkten verbleibenden Linien halber Lichtintensität können durch eine Überbelichtung beseitigt werden. Sofern ein Phasensprung von 180° durch die Maskenkanten erzeugt wird, ist die Strukturgröße die kleinstmögliche bei Vorgabe der Eigenschaften der optischen Abbildung wie der Wellenlänge, der numerischen Apertur oder der Kohärenz. Größere Strukturen können durch eng zusammenliegende Mehrfachlinien erzeugt werden.

## Patentansprüche

1. Verwendung einer Phasenmaske zum lithographischen Erzeugen kleiner Strukturen an der Grenze einer durch die wellenlänge einer Strahlung vorgegebenen Auflösung,
wobei die Phasenmaske erste Bereiche (A) und gegenüber den ersten Bereichen phasenschiebende zweite Bereiche (B) neben den ersten Bereichen zur Erzeugung eines Phasensprungs entlang von Grenzen zwischen den ersten und den zweiten Bereichen aufweist,
und wobei sich die ersten Bereiche über Ecken an Punkten (P) berühren, an denen sich auch die zweiten Bereiche über Ecken berühren, so daß an diesen Punkten Grenzen zwischen ersten und zweiten Bereichen zusammenlaufen und diese Punkte für die Strahlung undurchlässig sind,
**dadurch gekennzeichnet, daß** an den Schnittpunkten der Linien geringer Strahlungsintensität Kontaktlöcher erzeugt werden.

2. Verwendung nach Anspruch 1,
**dadurch gekennzeichnet,**
**daß** die Punkte Schnittpunkte von Grenzen zwischen ersten und zweiten Bereichen sind.

3. Verwendung nach Anspruch 1,
**dadurch gekennzeichnet,**
**daß** die Punkte Kreuzungspunkte von Grenzlinien zwischen ersten und zweiten Bereichen sind.

4. Verwendung nach einem der Ansprüche 1 bis 3,
**dadurch gekennzeichnet,**
**daß** sich die Grenzen oder Grenzlinien zwischen ersten und zweiten Bereichen in den Punkten im rechten Winkel schneiden.

5. Verwendung nach einem de Ansprüche 1 bis 4,
**dadurch gekennzeichnet,**
**daß** die zweiten Bereiche gegenüber den ersten Bereichen erhöht oder vertieft sind und die Grenzen zwischen ersten und zweiten Bereich Phasensprungkanten sind.

6. Verwendung nach Anspruch 5,
**dadurch gekennzeichnet,**
**daß** die Phasensprungkanten einen Phasensprung von einer halben Wellenlänge erzeugen.

7. Verwendung nach einem der Ansprüche 1 bis 6,
**dadurch gekennzeichnet,**
**daß** die ersten und die zweiten Bereiche auf der Phasenmaske schachbrettartig angeordnet sind.

8. Verfahren zum lithographischen Erzeugen kleiner Strukturen an der Grenze einer durch die Wellenlänge einer Strahlung vorgegebenen Auflösung,
bei dem ein Gegenstand in der Weise durch eine oder mehrere Phasenmasken belichtet wird, daß Linien geringer Strahlungsintensität so auf den Gegenstand projiziert werden, daß sie sich auf diesem schneiden,
und bei dem der Gegenstand durch die Phasenmaske hindurch nur ein einziges Mal belichtet wird,
wobei die Phasenmaske erste Bereiche (A) und gegenüber den ersten Bereichen phasenschiebende zweite Bereiche (B) neben den ersten Bereichen zur Erzeugung eines Phasensprungs entlang von Grenzen zwischen den ersten und den zweiten Bereichen aufweist,
und wobei sich die ersten Bereiche über Ecken an Punkten (P) berühren, an denen sich auch die zweiten Bereiche über Ecken berühren, so daß an diesen Punkten Grenzen zwischen ersten und zweiten Bereichen zusammenlaufen und diese Punkte für die Strahlung undurchlässig sind,
**dadurch gekennzeichnet, daß** an Schnittpunkten der Linien geringer Strahlungsintensität Kontaktlöcher erzeugt werden.

9. Verfahren nach Anspruch 8 **dadurch gekennzeichnet**, daß der Gegenstand durch eine nach einem der Ansprüche 1 bis 7 verwendete Phasenmaske hindurch belichtet wird.

10. Verfahren nach Anspruch 8 oder 9,
**dadurch gekennzeichnet,**
**daß** der Gegenstand ein Flächenbereich eines Halbleitersubstrats ist.

## Claims

1. Use of a phase mask for lithographically producing small structures at the limit of a resolution predetermined by the wavelength of a radiation, the phase mask having first regions (A) and second regions (B), which effect phase-shifting relative to the first regions, beside the first regions for producing a sudden phase shift along boundaries between the first and the second regions, and the first regions touching one another via corners at points (P) at which the second regions also touch one another via corners, with the result that boundaries between first and second regions merge at these points and these points are opaque to the radiation, **characterized in that** contact holes are produced at points of intersection of the lines of low radiation intensity.

2. Use according to Claim 1, **characterized in that** the points are points of intersection of boundaries between first and second regions.

3. Use according to Claim 1, **characterized in that** the points are crossover points of boundary lines between first and second regions.

4. Use according to one of Claims 1 to 3, **characterized in that** the boundaries or boundary lines between first and second regions intersect at right angles at the points.

5. Use according to one of Claims 1 to 4, **characterized in that** the second regions are raised or recessed relative to the first regions and the boundaries between first and second regions are sudden phase shift edges.

6. Use according to Claim 5, **characterized in that** the sudden phase shift edges produce a sudden phase shift of half a wavelength.

7. Use according to one of Claims 1 to 6, **characterized in that** the first and the second regions are arranged on the phase mask after the manner of a chessboard.

8. Method for lithographically producing small structures at the limit of a resolution predetermined by the wavelength of a radiation, in which an object is exposed through one or more phase masks in such a way that lines of low radiation intensity are projected onto the object in such a way that they intersect on said object, and in which the object is exposed through the phase mask just a single time, the phase mask having first regions (A) and second regions (B), which effect phase-shifting relative to the first regions, beside the first regions for producing a sudden phase shift along boundaries between the first and the second regions, and the first regions touching one another via corners at points (P) at which the second regions also touch one another via corners, with the result that boundaries between first and second regions merge at these points and these points are opaque to the radiation, **characterized in that** contact holes are produced at points of intersection of the lines of low radiation intensity.

9. Method according to Claim 8, **characterized in that** the object is exposed through a phase mask used according to one of Claims 1 to 7.

10. Method according to Claim 8 or 9, **characterized in that** the object is an area region of a semiconductor substrate.

## Revendications

1. Utilisation d'un masque de phase pour la production par lithographie de petites structures à la limite d'une résolution prescrite par la longueur d'onde d'un rayonnement,
dans laquelle le masque de phase a des premières régions (A) et des deuxièmes régions (B) déphasées par rapport aux premières régions et à côté des premières régions pour produire un saut de phase le long de limites entre les premières et les deuxièmes régions ;
et dans laquelle les premières régions se touchent par des coins en des points (P) où les deuxièmes régions se touchent aussi par des coins, de sorte qu'en ces points, des limites entre des premières et des deuxièmes régions se rejoignent et ces points sont imperméables aux rayonnements,
**caractérisée en ce que** des trous de contact sont produits aux points d'intersection des lignes de petite intensité de rayonnement.

2. Utilisation suivant la revendication 1,
**caractérisée**
**en ce que** les points sont des points d'intersection de limites entre des premières et des deuxièmes régions.

3. Utilisation suivant la revendication 1,
**caractérisée**
**en ce que** les points sont des points d'intersection de lignes limites entre des premières et des deuxièmes régions.

4. Utilisation suivant l'une des revendications 1 à 3,
**caractérisée**
**en ce que** les limites ou les lignes limites entre des premières et des deuxièmes régions se coupent en les points à angle droit.

5. Utilisation suivant l'une des revendications 1 à 4,
**caractérisée**
**en ce que** les deuxièmes régions sont surélevées ou abaissées par rapport aux premières régions et les limites entre des premières et des deuxièmes régions sont des bords de saut de phase.

6. Utilisation suivant la revendication 5,
**caractérisée**
**en ce que** les bords de saut de phase produisent un saut de phase d'une demi-longueur d'onde.

7. Utilisation suivant l'une des revendications 1 à 6,
**caractérisée**
**en ce que** les premières et les deuxièmes régions sont disposées en échiquier sur le masque de phase.

8. Procédé de production par lithographie de structures petites à la limite d'une résolution prescrite par la longueur d'onde d'un rayonnement,
dans lequel on expose à un rayonnement un objet à travers un ou plusieurs masques de phase de façon que les lignes d'intensité de rayonnement petite soient projetées sur l'objet de manière à se couper sur celui-ci,
et dans lequel on n'expose l'objet à un rayonnement à travers le masque de phase qu'une seule fois,
dans lequel le masque de phase a des premières régions (A) et des deuxièmes régions (B) déphasées par rapport aux premières régions et à côté des premières régions pour produire un saut de phase le long de limites entre les premières et les deuxièmes régions ;
et dans laquelle les premières régions se touchent par des coins en des points (P) où les deuxièmes régions se touchent aussi par des coins de sorte qu'en ces points des limites entre des premières et des deuxièmes régions se rejoignent et ces points sont imperméables au rayonnement,
**caractérisée en ce que** des trous de contact sont produits au point d'intersection des lignes de petite intensité de rayonnement.

9. Procédé suivant la revendication 8,
**caractérisé**
**en ce qu'**on expose l'objet à un rayonnement à travers un masque de phase utilisé suivant l'une des revendications 1 à 7.

10. Procédé suivant la revendication 8 ou 9,
**caractérisé**
**en ce que** l'objet est une région plane d'un substrat semiconducteur.
